# EUROPEAN PATENT SPECIFICATION

(11) **EP 3 514 762 B1**
(45) Date of publication and mention of the grant of the patent: **23.09.2020**
(21) Application number: 18212039.4
(22) Date of filing: 12.12.2018
(51) Int. Cl.: G06T 15/50, G06T 15/06, G06T 7/521

(54) **SIMULATION APPARATUS, METHOD OF ESTIMATING REFLECTION CHARACTERISTICS, AND PROGRAM**
SIMULATIONSVORRICHTUNG, VERFAHREN ZUM SCHÄTZEN VON REFLEXIONSEIGENSCHAFTEN UND PROGRAMM
APPAREIL DE SIMULATION, PROCÉDÉ D'ESTIMATION DE CARACTÉRISTIQUES DE RÉFLEXION ET PROGRAMME

(30) Priority: 17.01.2018 JP 2018005511
(43) Date of publication of application: 24.07.2019
(73) Proprietor: TOYOTA JIDOSHA KABUSHIKI KAISHA, Toyota-shi, Aichi 471 8571 (JP)
(72) Inventor: WASAKI, Tetsuya, Toyota-shi,, Aichi 471-8571 (JP); SASAKI, Tomomitsu, Toyota-shi,, Aichi 471-8571 (JP); KAYANO, Koichi, Toyota-shi,, Aichi 471-8571 (JP); NAKAZONO, Yukiko, Nagoya,, Aichi 461-0001, (JP)
(74) Representative: J A Kemp LLP

(56) References cited:
- US-A1- 2005 083 340
- US-A1- 2015 079 327
- WOLFGANG HEIDRICH ET AL: "Illuminating micro geometry based on precomputed visibility", COMPUTER GRAPHICS. SIGGRAPH 2000 CONFERENCE PROCEEDINGS. NEW ORLEANS, LA, JULY 23 - 28, 2000; [COMPUTER GRAPHICS PROCEEDINGS. SIGGRAPH], NEW YORK, NY : ACM, US, 1 July 2000 (2000-07-01), pages 455-464, XP058374807, DOI: 10.1145/344779.344984 ISBN: 978-1-58113-208-3
- YANG HAIYUE ET AL: "Simulated BRDF based on measured surface topography of metal", PROCEEDINGS OF SPIE; [PROCEEDINGS OF SPIE ISSN 0277-786X VOLUME 10524], SPIE, US, vol. 10334, 26 June 2017 (2017-06-26), pages 1033405-1033405, XP060092028, DOI: 10.1117/12.2269978 ISBN: 978-1-5106-1533-5

## Description

### BACKGROUND

The present disclosure relates to a simulation apparatus, a method of estimating reflection characteristics, and a program.

Since reflection characteristics of light in an object affect an appearance of a product, the reflection characteristics are used in a product development. For example, Japanese Unexamined Patent Application Publication No. 2015-049691 discloses a simulation apparatus used for the design development of vehicles. This simulation apparatus includes a Bidirectional Reflectance Distribution Function (BRDF) measurement unit configured to measure a BRDF and reproduce the appearance of a vehicle by a simulation based on the results of the measurement in the BRDF measurement unit.

WOLFGANG HEIDRICH ET AL: "Illuminating micro geometry based on precomputed visibility", COMPUTER GRAPHICS. SIGGRAPH 2000 CONFERENCE PROCEEDINGS. NEW ORLEANS, LA, JULY 23 - 28, 2000; [COMPUTER GRAPHICS PROCEEDINGS. SIGGRAPH], NEW YORK, NY : ACM, US, 1 July 2000 (2000-07-01), pages 455-464, XP058374807, DOI: 10.1145/344779.344984; ISBN: 978-1-58113-208-3; and YANG HAIYUE ET AL: "Simulated BRDF based on measured surface topography of metal", PROCEEDINGS OF SPIE; [PROCEEDINGS OF SPIE ISSN 0277-786X VOLUME 10524], SPIE, US, vol. 10334, 26 June 2017 (2017-06-26), pages 1033405-1033405, XP060092028, DOI: 10.1117/12.2269978; ISBN: 978-1-5106-1533-5; disclose background art.

### SUMMARY

The invention is defined by the appended claims. The reflection characteristics of the light in the object depend on a material of the object and a surface shape of the object. Therefore, different materials or different surface shapes cause different results in the measurement of the BRDF. Accordingly, when the BRDF of the object is acquired by the measurement, a sample of an actual object is required for each combination of the material and the surface shape. Further, it is required to perform a measurement work for each combination of the material and the surface shape.

The present disclosure has been made in view of the aforementioned circumstances and aims to provide a simulation apparatus, a method of estimating reflection characteristics, and a program capable of easily acquiring the reflection characteristics of the light in the object having a surface that has been embossed.

One aspect of the present disclosure to accomplish the aforementioned object is a simulation apparatus as defined in claim 1.

In this simulation apparatus, the shape data including the desired grain and secondary grain is generated. Then the reflection characteristics of the object of the desired material are estimated using this shape data. Therefore, there is no need to measure the object of the desired material that includes the desired grain and secondary grain. That is, there is no need to measure a sample of an actual object having a desired combination of the grain, the secondary grain, and the material. That is, since there is no need to prepare any sample of the actual object and to perform a measurement work, the reflection characteristics of the light in the object having a surface that has been embossed can be easily acquired.

In the aforementioned aspect, the grain shape storage unit may store shape data of each of a plurality of types of grains.

According to the aforementioned structure, the reflection characteristics of the light in the object having a shape of a grain arbitrarily selected from among the plurality of types of grains can be easily acquired. That is, the reflection characteristics of the light in the object when the shape of the grain has been changed can be easily acquired.

In the aforementioned aspect, the secondary grain shape storage unit may store shape data of each of the plurality of types of secondary grains.

According to the aforementioned structure, the reflection characteristics of the light in the object having a shape of a secondary grain arbitrarily selected from among the plurality of types of secondary grains can be easily acquired. That is, the reflection characteristics of the light in the object when the shape of the secondary grain has been changed can be easily acquired.

In the aforementioned aspect, the material storage unit may store data of optical characteristics of each of a plurality of kinds of material.

According to the aforementioned structure, the reflection characteristics of the light in the object of a material arbitrarily selected from among the plurality of kinds of material can be easily acquired. That is, the reflection characteristics of the light in the object when the material has been changed can be easily acquired.

According to the aforementioned structure, the optical characteristics specific to the material are estimated. Therefore, even when the optical characteristics of the material required to estimate the reflection characteristics of the light is not known in advance, the reflection characteristics of the light can be estimated.

Further, one aspect of the present disclosure to accomplish the aforementioned object is a method of estimating reflection characteristics as defined in claim 5.

In this estimation method, the shape data including the desired grain and secondary grain is generated. Then the reflection characteristics of the object of the desired material are estimated using this shape data. Therefore, there is no need to measure the object of the desired material that includes the desired grain and secondary grain. That is, there is no need to measure a sample of an actual object having a desired combination of the grain, the secondary grain, and the material. That is, since there is no need to prepare any sample of the actual object and to perform a measurement work, the reflection characteristics of the light in the object having a surface that has been embossed can be easily acquired.

Further, one aspect of the present disclosure to accomplish the aforementioned object is a program for causing a computer to execute the steps defined in claim 6.

In the processing by this program, the shape data including the desired grain and secondary grain is generated. Then the reflection characteristics of the object of the desired material are estimated using this shape data. Therefore, there is no need to measure the object of the desired material that includes the desired grain and secondary grain. That is, there is no need to measure a sample of an actual object having a desired combination of the grain, the secondary grain, and the material. That is, since there is no need to prepare any sample of the actual object and to perform a measurement work, the reflection characteristics of the light in the object having a surface that has been embossed can be easily acquired.

According to the present disclosure, it is possible to provide a simulation apparatus, a method of estimating reflection characteristics, and a program capable of easily acquiring the reflection characteristics of the light in the object having a surface that has been embossed.

The above and other objects, features and advantages of the present disclosure will become more fully understood from the detailed description given hereinbelow and the accompanying drawings which are given by way of illustration only, and thus are not to be considered as limiting the present disclosure.

### BRIEF DESCRIPTION OF DRAWINGS

Fig. 1 is a block diagram showing one example of a functional configuration of a simulation apparatus according to an embodiment;
Fig. 2 is a block diagram showing one example of a hardware configuration of the simulation apparatus according to this embodiment;
Fig. 3 is a flowchart showing one example of a flow of an operation for acquiring reflection characteristics of light in an object in the simulation apparatus according to this embodiment;
Fig. 4 is a flowchart showing one example of processing of combining shape data by a combination shape generator;
Fig. 5 is a flowchart showing one example of estimation processing by a reflection characteristic estimation unit;
Fig. 6 is a schematic view showing each point calculated in a ray-tracing simulation; and
Fig. 7 is a flowchart showing one example of estimation processing by the optical characteristic estimation unit.

### DESCRIPTION OF EMBODIMENTS

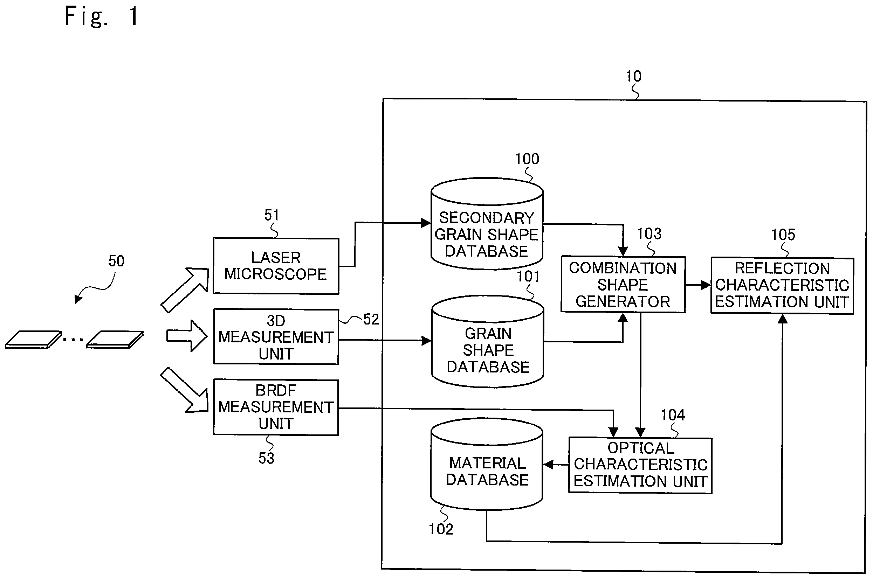

Hereinafter, with reference to the drawings, an embodiment of the present disclosure will be explained. Fig. 1 is a block diagram showing one example of a functional configuration of a simulation apparatus 10 according to this embodiment. Fig. 1 shows, besides the simulation apparatus 10, an apparatus for generating data to be input to the simulation apparatus 10 (a laser microscope 51, a 3D measurement unit 52, and a BRDF measurement unit 53), and a sample group 50, for the sake of explanation.

The simulation apparatus 10 is an apparatus configured to acquire reflection characteristics of light in an object by an estimation. The object whose reflection characteristics are to be acquired by the simulation apparatus 10 is, for example, an object made of resin, but is not limited thereto. The simulation apparatus 10 may acquire reflection characteristics of an object made of a desired material such as metal.

In this embodiment, the simulation apparatus 10 acquires reflection characteristics of an object whose surface is embossed. More specifically, the simulation apparatus 10 acquires reflection characteristics of an object having the following surfaces. That is, the simulation apparatus 10 acquires reflection characteristics of an object having a surface on which a grain and a secondary grain are formed. The grain is an irregular shape formed on the surface of the object. In other words, the grain is an irregular pattern formed on the surface of the object. The grain may be referred to as a primary grain. The secondary grain, which has an irregular shape finer than that of the grain, is a shape overlapped with the grain. In other words, the secondary grain, which has an irregular pattern finer than the irregular pattern of the grain, is a pattern formed on the grain. That is, the irregular pattern of the secondary grain is finer than the irregular pattern of the grain. Conversely, the irregular pattern of the grain is rougher than the irregular pattern of the secondary grain. In this way, a pattern that appears on the surface of the object, that is, the shape, is defined by a combination of the pattern of the grain and the pattern of the secondary grain.

Incidentally, the reflection characteristics of the light in the object depend on not only the shape of the surface of the object but also the material of the object. Therefore, when objects are made of materials different from one another, the reflection characteristics of these objects are different from one another even when these objects have the same surface shape. The number of reflection characteristics corresponds to the number of combinations made of the shape of the grain, the shape of the secondary grain, and the material of the object. In this embodiment, a ray-tracing simulation is performed for a desired combination selected from among the shape data of the grain, the shape data of the secondary grain, and the data of the material stored in a database in advance, thereby acquiring the reflection characteristics of the object that has this combination. While the reflection characteristics are specifically a BRDF in this embodiment, the simulation apparatus 10 may acquire reflection characteristics other than the BRDF.

As shown in Fig. 1, the simulation apparatus 10 includes a secondary grain shape database 100, a grain shape database 101, a material database 102, a combination shape generator 103, an optical characteristic estimation unit 104, and a reflection characteristic estimation unit 105. In this embodiment, the sample group 50, the laser microscope 51, the 3D measurement unit 52, and the BRDF measurement unit 53 are used in order to generate data to be stored in the secondary grain shape database 100, the grain shape database 101, and the material database 102.

The sample group 50 includes a sample of at least one actual object. However, in order to store various kinds of data in each database, the sample group 50 includes various samples.

In this embodiment, in order to store shape data of each of a plurality of types of grains in the grain shape database 101, samples of a plurality of objects that are made of the same material and have the same secondary grain shape but have grain shapes different from one another are prepared as the sample group 50. These samples may be, for example, samples of grains whose types of patterns (e.g., a leather pattern or a geometric pattern) are different from one another or may be samples of grains whose depths of the irregularities of the grains are different from one another.

Further, in this embodiment, in order to store shape data of each of a plurality of types of secondary grains in the secondary grain shape database 100, samples of a plurality of objects that are made of the same material and have the same grain shape but have secondary grain shapes different from one another are prepared as the sample group 50. These samples may be, for example, samples of the secondary grains whose fineness of the irregularities are different from one another.

Further, in this embodiment, in order to store data of optical characteristics of each of a plurality of kinds of material in the material database 102, samples of a plurality of objects that have the same grain shape and secondary grain shape but are made of materials different from one another are prepared as the sample group 50. These samples may be, for example, a sample made of an AES resin, a sample made of a POM resin, a sample made of a PP2 resin, and a sample made of a TPO resin etc.

Each sample included in the sample group 50 is measured by the laser microscope 51, the 3D measurement unit 52, and the BRDF measurement unit 53. The laser microscope 51 is one example of a measurement apparatus to acquire the shape data of the secondary grain that is present on the surface of the sample. The shape data of the secondary grain measured by the laser microscope 51 is input to the simulation apparatus 10 and is stored in the secondary grain shape database 100. Specifically, the shape data stored in the secondary grain shape database 100 is, for example, three-dimensional coordinate data. In this way, the secondary grain shape database 100 is a database that stores the shape data of the secondary grain. While the shape data stored in the secondary grain shape database 100 is shape data that includes not only the shape of the secondary grain but also irregularities due to the shape of the grain in this embodiment, shape data that does not include irregularities due to the shape of the grain, that is, shape data that specifies only the shape of the secondary grain may be stored in the secondary grain shape database 100. The secondary grain shape database 100 may be referred to as a secondary grain shape storage unit.

The 3D measurement unit 52 (three-dimensional measurement unit) is one example of a measurement apparatus to acquire the shape data of the grain that is present on the surface of the sample. The shape data of the grain measured by the 3D measurement unit 52 is input to the simulation apparatus 10 and is stored in the grain shape database 101. Specifically, the shape data stored in the grain shape database 101 is, for example, three-dimensional coordinate data. In this way, the grain shape database 101 is a database that stores the shape data of the grain. The grain shape database 101 may be referred to as a grain shape storage unit. In this embodiment, since the resolution of the 3D measurement unit 52 is not sufficiently high enough to measure the shape of the secondary grain, the shape data that does not include the irregularities due to the shape of the secondary grain, that is, the shape data that specifies only the shape of the grain, is stored in the grain shape database 101.

The BRDF measurement unit 53 is one example of the measurement apparatus for acquiring the reflection characteristics of the light in the sample. The BRDF measured by the BRDF measurement unit 53 is input to the simulation apparatus 10 and is used for the processing in the optical characteristic estimation unit 104.

The combination shape generator 103 combines the shape data stored in the grain shape database 101 with the shape data stored in the secondary grain shape database 100, thereby generating the shape data of the shape in which the secondary grain overlaps the grain. That is, the combination shape generator 103 generates data of the surface shape of the object. Specific processing by the combination shape generator 103 will be explained later with reference to a flowchart.

The optical characteristic estimation unit 104 estimates, using the measurement data of the reflection characteristics of the light in the object of a specific material and the estimation data of the reflection characteristics of the light obtained by the simulation using the shape data of the surface of this object, the optical characteristics specific to this specific material. Therefore, the optical characteristic estimation unit 104 requires the results of the measurement in the BRDF measurement unit 53 regarding the sample (this sample is referred to as a sample I) in the sample group 50 formed of the material whose optical characteristics are to be acquired and the shape data of the surface of the sample I when the optical characteristic estimation unit 104 estimates the optical characteristics of this material. While the optical characteristic estimation unit 104 uses the shape data generated by the combination shape generator 103 as the shape data of the surface of the sample I in this embodiment, the shape data used in the optical characteristic estimation unit 104 may not necessarily be the data generated by the combination shape generator 103. That is, the data of the surface shape of the object measured by the desired measurement unit may be used.

Specifically, the optical characteristic estimation unit 104 obtains the estimation data of the reflection characteristics of the light, that is, the estimation data of the BRDF, as follows. The optical characteristic estimation unit 104 sets temporary values as parameter values for the optical characteristics of the specific material, and performs the ray-tracing simulation using the optical characteristics specified by these values and the shape data of the surface of the object, thereby estimating the BRDF of this object.

Then the optical characteristic estimation unit 104 estimates, using results of estimating the BRDF and the results of measuring the BRDF of the sample of the actual object, the parameter values for the optical characteristics of the material.

The details of the processing by the optical characteristic estimation unit 104 will be explained later with reference to a flowchart. The optical characteristic estimation unit 104 stores the data of the optical characteristics that has been estimated, that is, the estimated parameter values, in the material database 102. In this way, the material database 102 is a database which stores data of the optical characteristics specific to the material of the object for each material. The material database 102 may be referred to as a material storage unit.

While the data of the optical characteristics is composed of a value of a parameter N, which is a real part of a complex index of refraction, a value of a parameter K, which is an imaginary part of the complex index of refraction, a value of a parameter G, which is an index value indicating scattering directivity (more specifically, a parameter of a Henyey-Greenstein phase function), and a value of a parameter D indicating diffuse reflectance in this embodiment, the simulation apparatus 10 may use optical characteristics other than the aforementioned ones. The data of the optical characteristics is data used to determine the behavior of the light beams in the ray-tracing simulation that will be described later.

The reflection characteristic estimation unit 105 estimates the reflection characteristics of the light in the object by the simulation using the shape data generated by the combination shape generator 103 and the data of the optical characteristics stored in the material database 102. The shape data of the surface that has been generated by the combination shape generator 103 and is used by the reflection characteristic estimation unit 105 is, for example, shape data indicating the desired grain shape and secondary grain shape specified by the user. Further, the data of the optical characteristics that is stored in the material database 102 and is used by the reflection characteristic estimation unit 105 is, for example, data of the optical characteristics that corresponds to a desired material specified by the user. Therefore, the reflection characteristic estimation unit 105 estimates the reflection characteristics of the light in the object having a desired combination of the grain, the secondary grain, and the material.

Specifically, the reflection characteristic estimation unit 105 estimates the BRDF of the desired object by performing the ray-tracing simulation using the shape data of the surface generated by the combination shape generator 103 and the data of the optical characteristics of the material that has been specified. The details of the processing by the reflection characteristic estimation unit 105 will be explained later with reference to a flowchart.

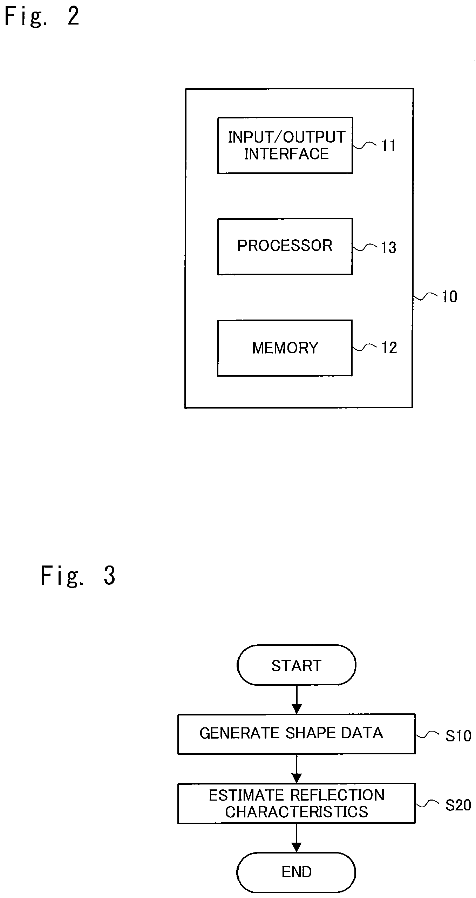

Next, one example of a hardware configuration of the simulation apparatus 10 will be explained. Fig. 2 is a block diagram showing one example of the hardware configuration of the simulation apparatus 10 according to this embodiment. As shown in Fig. 2, the simulation apparatus 10 includes an input/output interface 11, a memory 12, and a processor 13.

The input/output interface 11 is an interface for performing wired communication or wireless communication with another apparatus. The input/output interface 11 is used, for example, to receive data from the laser microscope 51, the 3D measurement unit 52, and the BRDF measurement unit 53. Further, for example, the input/output interface 11 is used to receive indication information from the user input through an input apparatus such as a keyboard.

The memory 12 is composed of a desired combination of a volatile memory and a nonvolatile memory. The memory 12 may include a plurality of memories. The memory 12 is used to store software (i.e., a computer program including one or more instructions) etc. executed by the processor 13.

The processor 13 loads software (computer program) from the memory 12 and executes the loaded software (computer program), thereby achieving the combination shape generator 103, the optical characteristic estimation unit 104, and the reflection characteristic estimation unit 105. As described above, the simulation apparatus 10 has a function as a computer. The processor 13 may be, for example, a microprocessor, a Micro Processing Unit (MPU), or a Central Processing Unit (CPU). The processor 13 may include a plurality of processors.

The aforementioned program(s) can be stored and provided to a computer using any type of non-transitory computer readable media. Non-transitory computer readable media include any type of tangible storage media. Examples of non-transitory computer readable media include magnetic storage media (such as flexible disks, magnetic tapes, hard disk drives, etc.), optical magnetic storage media (e.g., magneto-optical disks), Compact Disc Read Only Memory (CD-ROM), CD-R, CD-R/W, and semiconductor memories (such as mask ROM, Programmable ROM (PROM), Erasable PROM (EPROM), flash ROM, Random Access Memory (RAM), etc.). The program(s) may be provided to a computer using any type of transitory computer readable media. Examples of transitory computer readable media include electric signals, optical signals, and electromagnetic waves. Transitory computer readable media can provide the program to a computer via a wired communication line (e.g., electric wires, and optical fibers) or a wireless communication line.

The secondary grain shape database 100, the grain shape database 101, and the material database 102 may be achieved by, for example, a storage device such as the memory 12.

The combination shape generator 103, the optical characteristic estimation unit 104, and the reflection characteristic estimation unit 105 are not limited to be achieved by software by a program and each of them may be achieved by a hardware circuit, or may be achieved by, for example, any combination of hardware, firmware, and software.

Next, with reference to a flowchart, specific processing in the simulation apparatus 10 will be explained.

Fig. 3 is a flowchart showing one example of a flow of the operation for acquiring the reflection characteristics of the light in the object in the simulation apparatus 10. According to the simulation apparatus 10, a method of estimating the reflection characteristics as follows is executed.

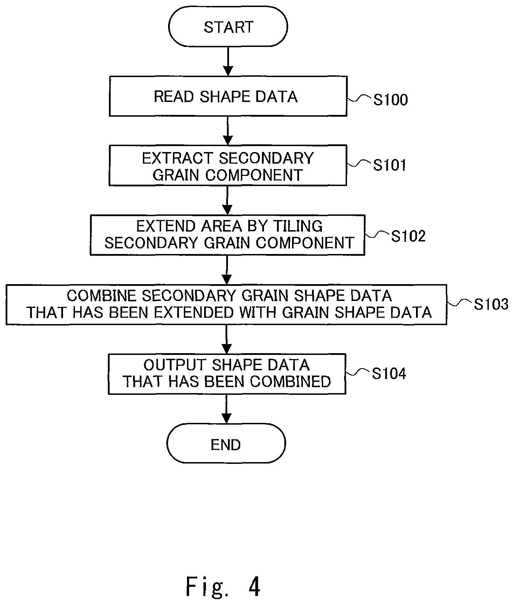

As shown in Fig. 3, first, in Step 10 (S10), the combination shape generator 103 combines the shape data of the grain with the shape data of the secondary grain, thereby generating the shape data of a shape in which the secondary grain overlaps the grain. A flow of specific processing of the combination shape generator 103 will be explained later with reference to Fig. 4.

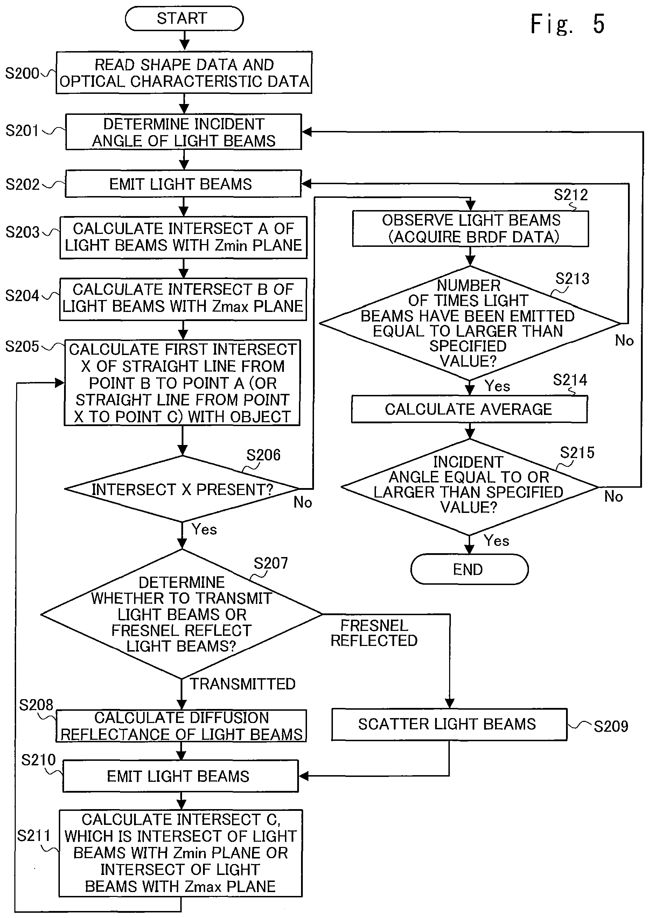

Next, in Step 20 (S20), the reflection characteristic estimation unit 105 estimates the reflection characteristics of the light in the object by a simulation using the shape data generated in Step 10 and data of the optical characteristics specific to the material of the object stored in the material database 102. The flow of specific processing of the reflection characteristic estimation unit 105 will be explained later with reference to Fig. 5.

Assume a case, for example, in which the user wants to acquire the BRDF of the surface of the object in a case in which the grain having a shape b and the secondary grain having a shape c are formed on the surface of the object made of a material a. In this case, in Step 10, the combination shape generator 103 reads out the shape data of the grain having the shape b specified by the user from the grain shape database 101, reads out the shape data of the secondary grain having the shape c from the secondary grain shape database 100, and combines the obtained data. Further, in Step 20, the reflection characteristic estimation unit 105 reads out data (i.e., the aforementioned parameters N, K, G, and D) of the optical characteristics that corresponds to the material a specified by the user from the material database 102 and estimates the reflection characteristics using the data that has been read out and the data generated in Step 10.

Fig. 4 is a flowchart showing one example of processing of combining the shape data by the combination shape generator 103. In the following description, with reference to Fig. 4, processing of the combination shape generator 103 will be explained.

In Step 100 (S100), the combination shape generator 103 reads the shape data stored in the grain shape database 101 and the shape data stored in the secondary grain shape database 100. The combination shape generator 103 reads, for example, the shape data specified by the user, as the target for the combination.

Next, in Step 101 (S101), the combination shape generator 103 extracts the secondary grain component regarding the shape data read out from the secondary grain shape database 100. As described above, in this embodiment, the shape data stored in the secondary grain shape database 100 includes, besides the shape of the secondary grain, shape data including irregularities due to the shape of the grain. Therefore, the combination shape generator 103 extracts the shape data that does not include irregularities due to the shape of the grain from the shape data obtained from the secondary grain shape database 100. The combination shape generator 103 calculates the shape data of only the secondary grain by calculating the difference between two pieces of shape data within one measurement range. Specifically, the combination shape generator 103 calculates the shape data of only the secondary grain by subtracting, from the height component (Z coordinate value) of the shape data read from the secondary grain shape database 100, the height component (Z coordinate value) of the shape data of the primary grain formed in the sample that has been used for the measurement to obtain this data.

Next, in Step 102 (S102), the combination shape generator 103 extends the area of the shape data of only the secondary grain component by tiling the secondary grain component extracted in Step 101. The range in the XY coordinates of the shape data obtained by the laser microscope 51 is limited. Therefore, the combination shape generator 103 extends the range in the XY coordinates of the shape data by replicating the shape data obtained in Step 101 and arranging them on a plane.

Next, in Step 103 (S103), the combination shape generator 103 combines the shape data of the secondary grain that has been extended with the shape data read out from the grain shape database 101. That is, the combination shape generator 103 generates the shape data indicating the shapes regarding the grain and the secondary grain by adding the height components (Z coordinate values) of two pieces of shape data.

Then, in Step 104 (S104), the combination shape generator 103 outputs the shape data that has been generated.

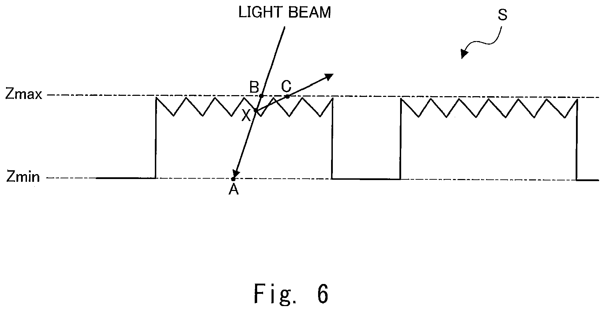

Fig. 5 is a flowchart showing one example of the estimation processing by the reflection characteristic estimation unit 105. Further, Fig. 6 is a schematic view showing each point calculated in the ray-tracing simulation. Fig. 6 shows points A, B, C, and X in a surface shape S of the object indicated by the shape data generated by the combination shape generator 103. While the reflection characteristic estimation unit 105 acquires the reflection characteristics of the light of the object by performing a simulation of Monte-Carlo ray tracing in this embodiment, the reflection characteristics of the light of the object may be acquired by performing a simulation by another ray tracing method. In the following processing, with reference to Fig. 5, processing of the reflection characteristic estimation unit 105 will be explained.

In Step 200 (S200), the reflection characteristic estimation unit 105 reads the shape data generated by the combination shape generator 103 and the data of the optical characteristics stored in the material database 102. In this case, the reflection characteristic estimation unit 105 reads, for example, data of the optical characteristics that corresponds to the material that has been specified by the user.

Next, in Step 201 (S201), the reflection characteristic estimation unit 105 determines the incident angle of the light beams emitted in the simulation. In this embodiment, as one example, the reflection characteristic estimation unit 105 acquires each of the BRDF when the light beams are made incident at an angle of 0 degrees, the BRDF when the light beams are made incident at an angle of 15 degrees, the BRDF when the light beams are made incident at an angle of 30 degrees, the BRDF when the light beams are made incident at an angle of 45 degrees, the BRDF when the light beams are made incident at an angle of 60 degrees, and the BRDF when the light beams are made incident at an angle of 75 degrees. Accordingly, every time the process goes to Step 201 in the flowchart, the reflection characteristic estimation unit 105 sets these incident angles in order.

Next, in Step 202 (S202), the reflection characteristic estimation unit 105 emits the light beams at an incident angle set in Step 201 toward a virtual object indicated by the shape data read in Step 200 in the simulation. The position of the virtual object where the light beams are made incident is determined by a random number.

Next, in Step 203 (S203), the reflection characteristic estimation unit 105 calculates an intersect A of the emitted light beams with a Zmin plane (see Fig. 6). The Zmin plane is an XY coordinate plane in which the Z coordinate is the minimum value in the height direction of the shape data.

Next, in Step 204 (S204), the reflection characteristic estimation unit 105 calculates the intersect B of the emitted light beams with a Zmax plane (see Fig. 6). The Zmax plane is an XY coordinate plane in which the Z coordinate is the maximum value in the height direction of the shape data.

Next, in Step 205 (S205), the reflection characteristic estimation unit 105 calculates the first intersect X of the straight line from the point B to the point A with the object (see Fig. 6). When the process has moved from Step 211 that will be described later to Step 205, the reflection characteristic estimation unit 105 calculates the first intersect of the straight line from the point X to the point C with the object as a new intersect X (see Fig. 6).

When the intersect X calculated in Step 205 is present (Yes in S206 of Fig. 5), the process moves to Step 207. When the intersect X calculated in Step 205 is not present (No in S206 of Fig. 5), the process goes to Step 212.

In Step 207 (S207), the reflection characteristic estimation unit 105 determines whether to cause the light beams to be transmitted through the object at the point X, which is the intersect of the virtual object with the light beams, or to cause the light beams to be Fresnel reflected on the surface of the object. The reflection characteristic estimation unit 105 determines the travelling direction of the light beams using a random number and the complex index of refraction (the parameter N and the parameter K) read out from the material database 102.

When the light beams are to be transmitted ("transmitted" in S207 of Fig. 5), the process moves to Step 208. When the light beams are to be Fresnel reflected ("Fresnel reflected" in S207 of Fig. 5), the process moves to Step 209.

In Step 208 (S208), the reflection characteristic estimation unit 105 calculates the diffusion reflectance of the light beams from the inside of the virtual object. Specifically, the reflection characteristic estimation unit 105 performs a simulation of the diffuse reflection using the diffuse reflectance (parameter D) read out from the material database 102. After Step 208, the process moves to Step 210.

On the other hand, in Step 209 (S209), the reflection characteristic estimation unit 105 scatters the light beams at the point X. The reflection characteristic estimation unit 105 performs simulation of the scattering of the light beams using the random number and an index value (parameter G) of the scattering directivity read from the material database 102. After Step 209, the process moves to Step 210.

In Step 210 (S210), the reflection characteristic estimation unit 105 emits the light beams from the point X based on the result of the calculation in Step 208 or Step 209.

Next, in Step 211 (S211), the reflection characteristic estimation unit 105 calculates the intersect C, which is the intersect of the light beams emitted in Step 210 with the Zmin plane or the Zmax plane (see Fig. 6). After Step 211, the process goes back to Step 205, where ray-tracing processing similar to that described above is performed.

When it is determined in Step 206 that there is no intersect X, the light beams are observed in Step 212 (S212). That is, the reflection characteristic estimation unit 105 acquires the intensity of the light observed at an observation point as the results of the ray-tracing simulation from Steps 202 to 211. That is, the reflection characteristic estimation unit 105 acquires the BRDF data that has been estimated by a single ray emission simulation.

Next, in Step 213 (S213), the reflection characteristic estimation unit 105 determines whether the number of times that the light beams have been emitted is equal to or larger than a specified value. When the number of emission times is equal to or larger than the specified value (Yes in S213 of Fig. 5), the process moves to Step 214. On the other hand, when the number of emission times is smaller than the specified value (No in S213 of Fig. 5), the process goes back to Step 202, where the light beams are emitted again. In this way, the ray-tracing simulation is repeated in such a way that the number of pieces of data acquired in Step 212 reaches the specified value.

In Step 214 (S214), the reflection characteristic estimation unit 105 calculates the average of the omnidirectional BRDF acquired in Step 212 and uses the result of the calculation as the estimation value of the omnidirectional BRDF with respect to the incident angle determined in Step 201.

Next, in Step 215 (S215), the reflection characteristic estimation unit 105 determines whether the incident angle that is currently set is equal to or larger than a specified value. In this embodiment, the reflection characteristic estimation unit 105 determines whether the incident angle that is currently set is equal to or larger than 75 degrees. When the incident angle that is currently set is equal to or larger than the specified value (Yes in S215 of Fig. 5), this means that the estimation value of the omnidirectional BRDF has been acquired for all the planned incident angles, and thus the processing series are ended. On the other hand, when the incident angle that is currently set is smaller than the specified value (No in S215 of Fig. 5), the process goes back to Step 201. That is, in this case, the next incident angle is set in Step 201. When, for example, the incident angle that is currently set is 0 degrees, the reflection characteristic estimation unit 105 updates the incident angle to 15 degrees in Step 201. Then the simulation at Step 202 and the following steps is repeated.

The operation of the simulation apparatus 10 for acquiring the reflection characteristics of the light in the object has been described above. In this embodiment, before the processing of the flowchart shown in Fig. 3 is executed, data of the optical characteristics for each material is stored in the material database 102 in advance. Further, in this embodiment, as described above, the optical characteristics estimated by the optical characteristic estimation unit 104 are stored in the material database 102. In the following description, the estimation processing of the optical characteristics will be explained.

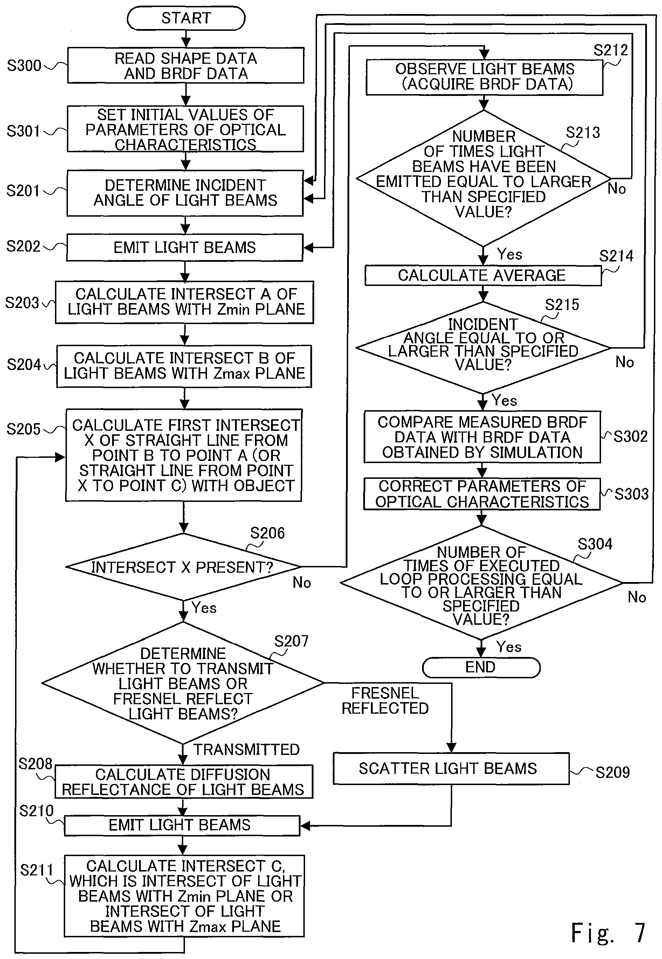

Fig. 7 is a flowchart showing one example of the estimation processing by the optical characteristic estimation unit 104. The optical characteristic estimation unit 104 executes a ray-tracing simulation similar to that performed in the reflection characteristic estimation unit 105, thereby estimating the omnidirectional BRDF of the object where the temporary values have been set as the parameter values of the optical characteristics. Then the optical characteristic estimation unit 104 updates the parameter values based on the results of the comparison between the omnidirectional BRDF that has been estimated and the omnidirectional BRDF obtained from the actual measurement. The optical characteristic estimation unit 104 stores, when the parameter values of the reflection characteristics in which the results of the estimation of the omnidirectional BRDF approximate to the results of measuring the omnidirectional BRDF are obtained, these parameter values in the material database 102. While the optical characteristic estimation unit 104 specifically determines the values of the parameters (N, K, G, and D) using a genetic algorithm in this embodiment, another desired search algorithm for searching for the values of the parameters (N, K, G, and D) in which the results of the estimation approximate to the results of the measurement may be used.

In the flowchart shown in Fig. 7, Step 200 shown in Fig. 5 is replaced by Steps 300 and 301, and Steps 302, 303, and 304 are added as the processing after Step 215 shown in Fig. 5. In the following description, with reference to the flowchart shown in Fig. 7, processing of the optical characteristic estimation unit 104 will be explained. However, the description regarding the steps that overlap with the processing contents shown in the flowchart in Fig. 5 will be omitted. Further, a case in which the optical characteristics regarding a material p are estimated will be explained as an example. Further, it is assumed that a shape q is formed on the surface in the sample I made of the material p. It is further assumed that this shape q is a shape obtained by combining the primary grain having a shape q₁ with the secondary grain having a shape q₂.

First, in Step 300 (S300), the optical characteristic estimation unit 104 reads the shape data generated by the combination shape generator 103 and the BRDF data of the sample I measured by the BRDF measurement unit 53. The shape data generated by the combination shape generator 103 is a shape obtained by combining the shape data of the shape q₁ for the primary grain with the shape data of the shape q₂ for the secondary grain. While the optical characteristic estimation unit 104 uses the shape data generated by the combination shape generator 103 as the shape data of the surface of the sample I in this example, when there is data of the surface shape of the sample I measured by the desired measurement unit, this data may be used. Further, in this case, the surface shape may not necessarily be the shape whose data is stored in the grain shape database 101 and the secondary grain shape database 100. That is, the sample I having a desired surface shape may be used.

Next, in Step 301 (S301), the optical characteristic estimation unit 104 sets initial values of the parameters (N, K, G, and D) of the optical characteristics. That is, the optical characteristic estimation unit 104 generates the individual in the first generation in the genetic algorithm using the random number.

After Step 301, the process moves to Step 201. In this way, the optical characteristic estimation unit 104 executes the processing series from Step 201 to Step 304. The processes from Steps 201 to 215 are similar to those shown in Fig. 5. That is, in the estimation processing by the optical characteristic estimation unit 104, the ray-tracing simulation is performed using the parameters of the temporary values (i.e., data of the optical characteristics where the temporary values are set) set in Step 301 or Step 303 that will be described later.

When it is determined in Step 215 that the incident angle that is currently set is equal to or larger than the specified value (Yes in S215 of Fig. 7), the process moves to Step 302.

In Step 302 (S302), the optical characteristic estimation unit 104 compares the measured BRDF data (i.e., the results of the measurement of the omnidirectional BRDF read in Step 300) with the BRDF data obtained by the simulation (i.e., the results of the estimation of the omnidirectional BRDF obtained by the processing from Steps 201 to 215). Specifically, the optical characteristic estimation unit 104 calculates the fitness of each individual in the current generation.

Next, in Step 303 (S303), the optical characteristic estimation unit 104 corrects the values of the parameters of the optical characteristics based on the results of the comparison in Step 302. That is, the optical characteristic estimation unit 104 generates the individual in the next generation based on the fitness of each individual calculated in Step 302.

Next, in Step 304 (S304), the optical characteristic estimation unit 104 determines whether the number of times of the executed loop processing (i.e., the number of times that the processing series from Steps 201 to 303 has been executed) is equal to or larger than a specified value. When the number of execution times is smaller than the specified value, the aforementioned processing continues to be repeated using the individual in the new generation. On the other hand, when the number of execution times is equal to or larger than the specified value, it is regarded that the parameter values of the reflection characteristics in which the results of the estimation of the omnidirectional BRDF approximate to the results of measuring the omnidirectional BRDF have been obtained, and thus the processing is ended.

The embodiment has been described above. In the simulation apparatus 10, the shape data of the shape in which the secondary grain overlaps the grain is generated by combining the shape data stored in the grain shape database 101 with the shape data stored in the secondary grain shape database 100. Then the reflection characteristics of the light in the object are estimated by a simulation using the shape data that has been generated and the data stored in the material database 102. Therefore, there is no need to measure the sample of the actual object having a desired combination of the grain, the secondary grain, and the material. Accordingly, the reflection characteristics of the light in the object having a surface that has been embossed can be easily acquired.

Further, the grain shape database 101 stores the shape data of each of a plurality of types of grains. Therefore, the reflection characteristics of the light in the object having a shape of a grain arbitrarily selected from among the plurality of types of grains can be easily acquired. That is, the reflection characteristics of the light in the object when the shape of the grain has been changed can be easily acquired. The number of types of the shape data stored in the grain shape database 101 may not be two or larger and may be only one.

Further, the secondary grain shape database 100 stores the shape data of each of a plurality of types of secondary grains. Therefore, the reflection characteristics of the light in the object having a shape of a secondary grain arbitrarily selected from among the plurality of types of secondary grains can be easily acquired. That is, the reflection characteristics of the light in the object when the shape of the secondary grain has been changed can be easily acquired. The number of types of the shape data stored in the secondary grain shape database 100 may not be two or larger and may be only one.

Further, the material database 102 stores data of the optical characteristics of each of a plurality of kinds of material. Therefore, the reflection characteristics of the light in the object of the material that has been arbitrarily selected from among the plurality of kinds of material can be easily acquired. That is, the reflection characteristics of the light in the object when the material has been changed can be easily acquired. The number of types of the material whose optical characteristics are stored in the material database 102 may not be two or larger and may be only one.

Further, the simulation apparatus 10 includes the optical characteristic estimation unit 104 configured to estimate the optical characteristics specific to the material. Therefore, even when the optical characteristics of the material required to estimate the reflection characteristics of the light are not known in advance, it is possible to estimate the reflection characteristics of the light.

The present disclosure is not limited to the aforementioned embodiment and may be changed as appropriate without departing from the scope of the present disclosure as defined by the claims.

## Claims

1. A simulation apparatus (10) comprising:
a grain shape storage unit (101) configured to store shape data of a grain acquired by a first measurement of the surface of a material sample object, which is an irregular shape formed on a surface of the object;
a secondary grain shape storage unit (100) configured to store shape data of a secondary grain, acquired by a second, higher-resolution, measurement of the surface of the material sample object, which has an irregular shape finer than that of the grain, the secondary grain having a shape overlapped with the grain;
a material storage unit (102) configured to store data of optical characteristics specific to a material;
a combination shape generator (103) configured to generate shape data of a surface in which the secondary grain overlaps the grain by combining the shape data stored in the grain shape storage unit with the shape data stored in the secondary grain shape storage unit;
a reflection characteristic estimation unit (105) configured to estimate reflection characteristics of light in objects by a ray tracing simulation using the shape data generated by the combination shape generator and the data of optical characteristics stored in the material storage unit;
wherein the data of optical characteristics comprises parameters determining the behavior of the light beams in the ray tracing simulation; and
the apparatus is **characterised by** further comprising
an optical characteristic estimation unit (104) configured to estimate optical characteristics specific to the material of the material sample object by setting initial values of the parameters of optical characteristics and iteratively comparing measurement data of reflection characteristics of light in the material sample object and the estimation data of reflection characteristics of light obtained by the ray tracing simulation with the parameters of optical characteristics using the shape data of the surface of the material sample object and correcting the parameters of optical characteristics based on the result of the comparison,
wherein the material storage unit stores data of the optical characteristics that have been estimated by the optical characteristic estimation unit after a specified number of iterations.

2. The simulation apparatus according to Claim 1, wherein the grain shape storage unit stores shape data of each of a plurality of types of grain.

3. The simulation apparatus according to Claim 1 or 2, wherein the secondary grain shape storage unit stores shape data of each of a plurality of types of secondary grains.

4. The simulation apparatus according to any one of Claims 1 to 3, wherein the material storage unit stores data of optical characteristics of each of a plurality of kinds of material.

5. A method of estimating reflection characteristics, the method comprising:
estimating optical characteristics data specific to the material of a material sample object, the optical characteristics data comprising parameters determining the behaviour of the light beams in a ray tracing simulation;
generating shape data of a surface in which a secondary grain overlaps a grain by combining stored shape data of the grain, which is an irregular shape formed on a surface of an object, with stored shape data of the secondary grain, which has an irregular shape finer than that of the grain, the secondary grain having a shape overlapped with the grain, the stored shape data of the grain being acquired by a first measurement of the surface of the material sample object, the stored shape data of the secondary grain being acquired by a second, higher-resolution, measurement of the surface of the material sample object; and
estimating reflection characteristics of light in objects by the ray tracing simulation using the shape data that has been generated and the estimated optical characteristics data
wherein, in the step of estimating optical characteristics data, the optical characteristics data specific to the material of the material sample object is estimated by setting initial values of the parameters of optical characteristics and iteratively comparing measurement data of reflection characteristics of light in the material sample object and the estimation data of reflection characteristics of light obtained by the ray tracing simulation with the parameters of optical characteristics using the shape data of the surface of the material sample object and correcting the parameters of optical characteristics based on the result of the comparison and storing data of the optical characteristics that have been estimated after a specified number of iterations.

6. A program for causing a computer to execute the following steps of:
an optical characteristic estimation step for estimating optical characteristics data specific to the material of a material sample, the optical characteristics data comprising parameters determining the behaviour of the light beams in a ray tracing simulation;
a combination shape generation step (S10) for generating shape data of a surface in which a secondary grain overlaps a grain by combining stored shape data of the grain, which is an irregular shape formed on a surface of an object, with stored shape data of the secondary grain which has an irregular shape finer than that of the grain, the secondary grain having a shape overlapped with the grain, the stored shape data of the grain being acquired by a first measurement of the surface of a material sample object, the stored shape data of the secondary grain being acquired by a second, higher-resolution, measurement of the surface of a material sample object; and
a reflection characteristic estimation step (S20) for estimating reflection characteristics of light in objects by the ray tracing simulation using the shape data that has been generated and the estimated optical characteristics data;
wherein, in the optical characteristic estimation step, the optical characteristics data specific to the material of the material sample object is estimated by setting initial values of the parameters of optical characteristics and iteratively comparing measurement data of reflection characteristics of light in the material sample object and the estimation data of reflection characteristics of light obtained by the ray tracing simulation with the parameters of optical characteristics using the shape data of the surface of the material sample object and correcting the parameters of optical characteristics based on the result of the comparison and storing data of the optical characteristics that have been estimated after a specified number of iterations.

## Patentansprüche

1. Simulationsvorrichtung (10), umfassend:
eine Kornform-Speichereinheit (101), die konfiguriert ist, um Formdaten eines Korns zu speichern, die durch eine erste Messung der Oberfläche eines Materialprobeobjekts erworben werden, das eine unregelmäßige Form ist, die auf einer Oberfläche des Objekts gebildet ist;
eine Sekundärkornform-Speichereinheit (100), die konfiguriert ist, um Formdaten eines Sekundärkorns zu speichern, die durch eine zweite Messung mit höherer Auflösung der Oberfläche des Materialprobeobjekts erworben werden, das eine unregelmäßige Form hat, die feiner als die des Korns ist, wobei das Sekundärkorn eine Form hat, die sich mit dem Korn überlagert;
eine Materialspeichereinheit (102), die konfiguriert ist, um Daten von optischen Eigenschaften zu speichern, die spezifisch für ein Material sind;
einen Kombinationsformgenerator (103), der konfiguriert ist, um Formdaten einer Oberfläche zu erzeugen, bei der das Sekundärkorn das Korn überlagert, durch Kombinieren der Formdaten, die in der Kornform-Speichereinheit gespeichert sind, mit den Formdaten, die in der Sekundärkornform-Speichereinheit gespeichert sind;
eine Reflexionseigenschaft-Schätzeinheit (105), die konfiguriert ist, um Reflexionseigenschaften von Licht in Objekten durch eine Strahlenverfolgungssimulation unter Verwendung der Formdaten, die durch den Kombinationsformgenerator erzeugt werden, und der Daten von optischen Eigenschaften, die in der Materialspeichereinheit gespeichert sind, zu schätzen;
wobei die Daten von optischen Eigenschaften Parameter umfassen, die das Verhalten der Lichtstrahlen in der Strahlenverfolgungssimulation bestimmen; und
die Vorrichtung **dadurch gekennzeichnet ist, dass** sie ferner Folgendes umfasst
eine Schätzeinheit für optische Eigenschaften (104), die konfiguriert ist, um optische Eigenschaften zu schätzen, die spezifisch für das Material des Materialprobeobjekts sind, durch Festlegen von Anfangswerten der Parameter von optischen Eigenschaften und iteratives Vergleichen von Messdaten von Reflexionseigenschaften von Licht in dem Materialprobeobjekt und der Schätzdaten von Reflexionseigenschaften von Licht, die durch die Strahlenverfolgungssimulation erhalten werden, mit den Parametern von optischen Eigenschaften unter Verwendung der Formdaten der Oberfläche des Materialprobeobjekts, und Korrigieren der Parameter von optischen Eigenschaften basierend auf dem Ergebnis des Vergleichs,
wobei die Materialspeichereinheit Daten der optischen Eigenschaften speichert, die durch die Schätzeinheit für optische Eigenschaften nach einer bestimmten Anzahl von Wiederholungen geschätzt wurden.

2. Simulationsvorrichtung nach Anspruch 1, wobei die Kornform-Speichereinheit Formdaten von jeder einer Vielzahl von Arten von Korn speichert.

3. Simulationsvorrichtung nach Anspruch 1 oder 2, wobei die Sekundärkornform-Speichereinheit Formdaten von jeder einer Vielzahl von Arten von Sekundärkörnern speichert.

4. Simulationsvorrichtung nach einem der Ansprüche 1 bis 3, wobei die Materialspeichereinheit Daten von optischen Eigenschaften von jeder einer Vielzahl von Arten von Material speichert.

5. Verfahren des Schätzens von Reflexionseigenschaften, wobei das Verfahren Folgendes umfasst:
Schätzen von Daten optischer Eigenschaften, die spezifisch für das Material eines Materialprobeobjekts sind, wobei die Daten optischer Eigenschaften Parameter umfassen, die das Verhalten der Lichtstrahlen in einer Strahlenverfolgungssimulation bestimmen;
Erzeugen von Formdaten einer Oberfläche, bei der ein Sekundärkorn ein Korn überlagert, durch Kombinieren gespeicherter Formdaten des Korns, das eine unregelmäßige Form hat, die auf einer Oberfläche eines Objekts gebildet ist, mit gespeicherten Formdaten des Sekundärkorns, das eine unregelmäßige Form hat, die feiner als die des Korns ist, wobei das Sekundärkorn eine Form hat, die sich mit dem Korn überlagert, wobei die gespeicherten Formdaten des Korns durch eine erste Messung der Oberfläche des Materialprobeobjekts erworben werden, wobei die gespeicherten Formdaten des Sekundärkorns durch eine zweite Messung mit höherer Auflösung der Oberfläche des Materialprobeobjekts erworben werden; und
Schätzen von Reflexionseigenschaften von Licht in Objekten durch die Strahlenverfolgungssimulation unter Verwendung der Formdaten, die erzeugt wurden, und der geschätzten Daten von optischen Eigenschaften,
wobei im Schritt des Schätzens von Daten optischer Eigenschaften die Daten optischer Eigenschaften, die spezifisch für das Material des Materialprobeobjekts sind, durch Festlegen von Anfangswerten der Parameter von optischen Eigenschaften und iteratives Vergleichen von Messdaten von Reflexionseigenschaften von Licht in dem Materialprobeobjekt und der Schätzdaten von Reflexionseigenschaften von Licht, die durch die Strahlenverfolgungssimulation erhalten werden, mit den Parametern von optischen Eigenschaften unter Verwendung der Formdaten der Oberfläche des Materialprobeobj ekts, und Korrigieren der Parameter von optischen Eigenschaften basierend auf dem Ergebnis des Vergleichs und Speichern von Daten der optischen Eigenschaften, die nach einer bestimmten Anzahl von Wiederholungen geschätzt wurden, geschätzt werden.

6. Programm zum Verursachen, dass ein Computer die folgenden Schritte ausführt:
einen Schätzschritt für optische Eigenschaften zum Schätzen von Daten optischer Eigenschaften, die spezifisch für das Material einer Materialprobe sind, wobei die Daten optischer Eigenschaften Parameter umfassen, die das Verhalten der Lichtstrahlen in einer Strahlenverfolgungssimulation bestimmen;
einen Kombinationsform-Erzeugungsschritt (S10) zum Erzeugen von Formdaten einer Oberfläche, bei der ein Sekundärkorn ein Korn überlagert, durch Kombinieren gespeicherter Formdaten des Korns, das eine unregelmäßige Form hat, die auf einer Oberfläche eines Objekts gebildet ist, mit gespeicherten Formdaten des Sekundärkorns, das eine unregelmäßige Form hat, die feiner als die des Korns ist, wobei das Sekundärkorn eine Form hat, die sich mit dem Korn überlagert, wobei die gespeicherten Formdaten des Korns durch eine erste Messung der Oberfläche eines Materialprobeobjekts erworben werden, wobei die gespeicherten Formdaten des Sekundärkorns durch eine zweite Messung mit höherer Auflösung der Oberfläche eines Materialprobeobjekts erworben werden; und
einen Reflexionseigenschaften-Schätzschritt (S20) zum Schätzen von Reflexionseigenschaften von Licht in Objekten durch die Strahlenverfolgungssimulation unter Verwendung der Formdaten, die erzeugt wurden, und der geschätzten Daten von optischen Eigenschaften;
wobei im Schätzschritt für optische Eigenschaften die Daten optischer Eigenschaften, die spezifisch für das Material des Materialprobeobjekts sind, durch Festlegen von Anfangswerten der Parameter von optischen Eigenschaften und iteratives Vergleichen von Messdaten von Reflexionseigenschaften von Licht in dem Materialprobeobjekt und der Schätzdaten von Reflexionseigenschaften von Licht, die durch die Strahlenverfolgungssimulation erhalten werden, mit den Parametern von optischen Eigenschaften unter Verwendung der Formdaten der Oberfläche des Materialprobeobjekts, und Korrigieren der Parameter von optischen Eigenschaften basierend auf dem Ergebnis des Vergleichs und Speichern von Daten der optischen Eigenschaften, die nach einer bestimmten Anzahl von Wiederholungen geschätzt wurden, geschätzt werden.

## Revendications

1. Appareil de simulation (10), comprenant :
une unité de stockage de forme de grain (101) configurée pour stocker des données de forme d'un grain, acquises par l'intermédiaire d'une première mesure de la surface d'un objet d'échantillon de matériau, qui est une forme irrégulière formée sur une surface de l'objet ;
une unité de stockage de forme de grain secondaire (100) configurée pour stocker des données de forme d'un grain secondaire, acquises par l'intermédiaire d'une seconde mesure, de résolution plus élevée, de la surface de l'objet d'échantillon de matériau, qui a une forme irrégulière plus fine que celle du grain, le grain secondaire ayant une forme que le grain chevauche ;
une unité de stockage de matériau (102) configurée pour stocker des données de caractéristiques optiques spécifiques à un matériau ;
un générateur de forme de combinaison (103) configuré pour générer des données de forme d'une surface dans laquelle le grain secondaire chevauche le grain en combinant des données de forme stockées dans l'unité de stockage de forme de grain avec les données de forme stockées dans l'unité de stockage de forme de grain secondaire ;
une unité d'estimation de caractéristiques de réflexion (105) configurée pour estimer des caractéristiques de réflexion de lumière dans des objets par l'intermédiaire d'une simulation par lancer de rayon en utilisant les données de forme générées par le générateur de forme de combinaison et les données de caractéristiques optiques stockées dans l'unité de stockage de matériau ;
dans lequel les données de caractéristiques optiques comprennent des paramètres déterminant le comportement des faisceaux de lumière dans la simulation par lancer de rayon ; et
l'appareil est **caractérisé en ce qu'**il comprend en outre
une unité d'estimation de caractéristiques optiques (104) configurée pour estimer des caractéristiques optiques spécifiques au matériau de l'objet d'échantillon de matériau en réglant des valeurs initiales des paramètres de caractéristiques optiques et comparant itérativement des données de mesure de caractéristiques de réflexion de lumière dans l'objet d'échantillon de matériau et les données d'estimation de caractéristiques de réflexion de lumière obtenues par l'intermédiaire de la simulation par lancer de rayon aux paramètres de caractéristiques optiques en utilisant les données de forme de la surface de l'objet d'échantillon de matériau et corrigeant les paramètres de caractéristiques optiques sur la base du résultat de la comparaison,
dans lequel l'unité de stockage de matériau stocke des données des caractéristiques optiques qui ont été estimées par l'unité d'estimation de caractéristiques optiques après un nombre spécifié d'itérations.

2. Appareil de simulation selon la revendication 1, dans lequel l'unité de stockage de forme de grain stocke des données de forme de chacun d'une pluralité de types de grain.

3. Appareil de simulation selon la revendication 1 ou 2, dans lequel l'unité de stockage de forme de grain secondaire stocke des données de forme de chacun d'une pluralité de types de grain secondaires.

4. Appareil de simulation selon l'une quelconque des revendications 1 à 3, dans lequel l'unité de stockage de matériau stocke des données de caractéristiques optiques de chacune d'une pluralité de sortes de matériau.

5. Procédé d'estimation de caractéristiques de réflexion, le procédé comprenant :
l'estimation de données de caractéristiques optiques spécifiques au matériau d'un objet d'échantillon de matériau, les données de caractéristiques optiques comprenant des paramètres déterminant le comportement des faisceaux de lumière dans une simulation par lancer de rayon ;
la génération de données de forme d'une surface dans laquelle un grain secondaire chevauche un grain en combinant des données de forme stockées du grain, qui est une forme irrégulière formée sur une surface d'un objet, avec des données de forme stockées du grain secondaire, qui a une forme irrégulière plus fine que celle du grain, le grain secondaire ayant une forme que le grain chevauche, les données de forme stockées du grain étant acquises par l'intermédiaire d'une première mesure de la surface de l'objet d'échantillon de matériau, les données de forme stockées du grain secondaire étant acquises par l'intermédiaire d'une seconde mesure, de résolution plus élevée, de la surface de l'objet d'échantillon de matériau ; et
l'estimation de caractéristiques de réflexion de lumière dans des objets par l'intermédiaire de la simulation par lancer de rayon en utilisant les données de forme qui ont été générées et les données de caractéristiques optiques estimées,
dans lequel, dans l'étape de l'estimation de données de caractéristiques optiques, les données de caractéristiques optiques spécifiques au matériau de l'objet d'échantillon de matériau sont estimées en réglant des valeurs initiales des paramètres de caractéristiques optiques et comparant itérativement des données de mesure de caractéristiques de réflexion de lumière dans l'objet d'échantillon de matériau et les données d'estimation de caractéristiques de réflexion de lumière obtenues par l'intermédiaire de la simulation par lancer de rayon aux paramètres de caractéristiques optiques en utilisant les données de forme de la surface de l'objet d'échantillon de matériau et corrigeant les paramètres de caractéristiques optiques sur la base du résultat de la comparaison et stockant des données des caractéristiques optiques qui ont été estimées après un nombre spécifié d'itérations.

6. Programme pour faire en sorte qu'un ordinateur exécute les étapes suivantes de :
une étape d'estimation de caractéristiques optiques pour estimer des données de caractéristiques optiques spécifiques au matériau d'un échantillon de matériau, les données de caractéristiques optiques comprenant des paramètres déterminant le comportement des faisceaux de lumière dans une simulation par lancer de rayon ;
une étape de génération de forme de combinaison (S10) pour générer des données de forme d'une surface dans laquelle un grain secondaire chevauche un grain en combinant des données de forme stockées du grain, qui est une forme irrégulière formée sur une surface d'un objet, avec des données de forme stockées du grain secondaire qui a une forme irrégulière plus fine que celle du grain, le grain secondaire ayant une forme que le grain chevauche, les données de forme stockées du grain étant acquises par l'intermédiaire d'une première mesure de la surface d'un objet d'échantillon de matériau, les données de forme stockées du grain secondaire étant acquises par l'intermédiaire d'une seconde mesure, de résolution plus élevée, de la surface d'un objet d'échantillon de matériau ; et
une étape d'estimation de caractéristiques de réflexion (S20) pour estimer des caractéristiques de réflexion de lumière dans des objets par l'intermédiaire de la simulation par lancer de rayon en utilisant les données de forme qui ont été générées et les données de caractéristiques optiques estimées ;
dans lequel, dans l'étape d'estimation de caractéristiques optiques, les données de caractéristiques optiques spécifiques au matériau de l'objet d'échantillon de matériau sont estimées en réglant des valeurs initiales des paramètres de caractéristiques optiques et comparant itérativement des données de mesure de caractéristiques de réflexion de lumière dans l'objet d'échantillon de matériau et les données d'estimation de caractéristiques de réflexion de lumière obtenues par l'intermédiaire de la simulation par lancer de rayon aux paramètres de caractéristiques optiques en utilisant les données de forme de la surface de l'objet d'échantillon de matériau et corrigeant les paramètres de caractéristiques optiques sur la base du résultat de la comparaison et stockant des données des caractéristiques optiques qui ont été estimées après un nombre spécifié d'itérations.
